# EUROPÄISCHE PATENTANMELDUNG

(11) **EP 0 950 729 A2**
(43) Veröffentlichungstag der Anmeldung: **20.10.1999**
(21) Anmeldenummer: 99105279.6
(22) Anmeldetag: 15.03.1999
(51) Int. Cl.: C25D 17/00, H05K 3/24

(54) **Galvanisiereinrichtung für plattenförmige Werkstücke, insbesondere Leiterplatten**

(30) Priorität: 23.03.1998 DE 19812639
(71) Anmelder: Siemens Automotive S.A., 1060 Bruxelles (BE)
(72) Erfinder: Denys, Wilfried, 8020 Oostkamp (BE)
(74) Vertreter: Epping, Wilhelm, Dr.-Ing.

(57) **Zusammenfassung**

Die kathodische Kontaktierung der horizontal durch einen Elektrolyten geführten Werkstücke erfolgt durch drehbar angeordnete Kontaktierorgane (K1, K2). Metallniederschläge auf den Kontaktierorganen (K1,K2) werden elektrolytisch wieder abgetragen und auf mindestens einer biegsamen, endlos umlaufenden Hilfskathode (H1, H2) abgeschieden. Die Entmetallisierung der Hilfskathoden (H1,H2) erfolgt in ihren außerhalb der Behandlungszelle (BZ) liegenden Rücklaufbereich mechanisch, chemisch oder elektrolytisch.

## Beschreibung

Es sind Galvanisiereinrichtungen bekannt, bei welchen plattenförmige Werkstücke, wie z.B. Leiterplatten, im horizontalen Durchlauf durch einen Elektrolyten transportiert werden, wobei der Vorschub und die kathodische Kontaktierung der durchlaufenden Werkstücke durch paarweise entlang einer Seite des Förderweges im Elektrolyten angeordnete Kontaktierrollen vorgenommen wird. Zum Schutz der Kontaktierrollen vor dem Elektrolyten sind sich in Durchlaufrichtung erstreckende Abschirmungen mit an dem jeweiligen Werkstück anliegenden Dichtleisten vorgesehen (US-A-4 385 967).

Bei der vorstehend geschilderten Galvanisiereinrichtung kann auch die Verwendung einer Abschirmung den Zutritt des Elektrolyten zum seitlichen Kontaktierungsbereich der Werkstücke und zu den Kontaktierrollen nicht vollständig verhindern. Als Folge dieser unvollständigen Abschirmung kommt es zu schwammigen Metallabscheidungen im Kontaktierbereich, zu einer rapiden Verschlechterung der Rollkontakte und zu ungünstigen Schichtdickenverteilungen der galvanisch abgeschiedenen Schichten bzw. zu einer starken Streuung der Schichtdicke. Außerdem müssen die Kontaktierrollen zur Entfernung der unerwünschten Metallabscheidungen immer wieder ausgebaut, von den Metallabscheidungen gesäubert und erneut montiert werden.

Im Hinblick auf die geschilderten Nachteile einer Rollkontaktierung der Werkstücke wurde auch bereits vorgeschlagen, bei derartigen Galvanisierungseinrichtungen als Kontaktier- und Transportmittel eine endlos umlaufende, angetriebene Reihe einzelner Klemmorgane vorzusehen, welche die Seitenränder der plattenförmigen Werkstücke festhalten und in der Transportrichtung bewegen. Zu Beginn und zu Ende des Transportweges durch den Elektrolyten sind hierbei Mittel erforderlich, die ein Erfassen der plattenförmigen Werkstücke duch die Klemmorgane bzw. das Freigeben der plattenförmigen Werkstücke durch die Klemmorgane bewirken. Bei dieser Lösung können unerwünschte Metallabscheidungen auf den endlos umlaufenden Klemmorganen außerhalb der Galvanisierzelle in einer separaten Entmetallisierungs-Station beispielsweise mechanisch oder chemisch durch Ätzen wieder abgetragen werden, (US-A-4 755 271).

Aus der EP-B-0 578 699 ist eine weitere Galvanisiereinrichtung bekannt, bei welcher die kathodische Kontaktierung der horizontal durchlaufenden Werkstücke durch drehbar angeordnete Kontaktierorgane, wie z.B. die eingangs erwähnten Kontaktierrollen erfolgt. Unerwünschte Metallniederschläge auf den Kontaktierorganen werden hier jedoch an Ort und Stelle elektrolytisch wieder abgetragen. Hierzu werden die Kontaktierorgane in bezug auf mindestens eine im Elektrolyten angeordnete Hilfskathode anodisch geschaltet. Die unerwünschten Metallabscheidungen auf den Kontaktierorganen werden also selbsttätig laufend wieder entfernt, bevor es zu einer Beeinträchtigung der Kontaktierierung der Werkstücke und damit zu einer Streuung der Schichtdicke der galvanisch abgeschiedenen Schichten kommt.

Bei der vorstehend geschilderten Entmetallisierung der Kontaktierorgane wird das elektrolytisch abgetragene Metall auf den Hilfskathoden wieder abgeschieden. Die Hilfskathoden müssen daher in regelmäßigen Abständen ausgewechselt werden, wobei dieser Wechsel aber nur bei Stillstand der Galvanisiereinrichtung vorgenommen werden kann. In der Leiterplattenfertigung muß beispielsweise die Galvanisiereinrichtung zum Wechsel der Hilfskathoden einmal pro Tag abgeschaltet werden.

Der im Anspruch 1 angegebenen Erfindung liegt das Problem zugrunde, bei einer Galvanisiereinrichtung für im horizontalen Durchlauf zu behandelnde plattenförmige Werkstücke einerseits mittels Hilfskathoden eine ständige Entmetallisierung der Kontaktierorgane zu bewirken und andererseits mit einem Wechsel der Hilfskathoden verbundene Stillstandszeiten zu vermeiden.

Der Erfindung liegt die Erkenntnis zugrunde, daß anstelle der statisch im Elektrolyten angeordneten Hilfskathoden biegsame und endlos umlaufende Hilfskathoden verwendet werden können, die dann in ihrem außerhalb der Behandlungszelle liegenden Rücklaufbereich ohne Stillstand der Galvanisiereinrichtung von den Metallniederschlägen wieder befreit werden können. Der Umlauf der Hilfskathoden kann dabei sowohl kontinuierlich als auch schrittweise vorgenommen werden.

Vorteilhafte Ausgestaltungen der Erfindung sind in den Unteransprüchen angegeben.

Die Ausgestaltung nach Anspruch 2 ermöglicht eine besonders einfache Führung der Hilfskathode durch die Behandlungszelle und durch die Entmetallisierungs-Station.

Die Weiterbildung nach Anspruch 3 ermöglicht eine wartungsfreundliche Anordnung der Entmetallisierungs-Station neben der Behandlungszelle.

Die Ausgestaltung nach Anspruch 4 erleichtert durch die den Stirnseiten der Kontaktierorgane unmittelbar gegenüberliegenden Ansatzstücke die Entmetallisierung der Kontaktierorgane.

Obwohl beispielsweise eine mechanische Entmetallisierung der Hilfskathoden grundsätzlich möglich ist, wird die Entfernung der Metallniederschläge in einem Entmetallisierungsbad gemäß Anspruch 5 bevorzugt, zumal sie besonders einfach und wartungsfreundlich vorgenommen werden kann. Als Entmetallisierungsband kann hierbei gemäß Anspruch 6 eine Ätzlösung oder gemäß Anspruch 7 ein Elektrolyt vorgesehen sein, wobei in letzterem Falle die Metallabscheidungen elektrolytisch abgetragen werden. Dabei kann sogar der gleiche Elektrolyt wie in der Behandlungszelle verwendet werden, so daß eine mögliche Verschleppung des Entmetallisierungsbades zu keinerlei Beeinträchtungen des Galvansiervorgangs führen würde.

Die Ausgestaltung nach Anspruch 8 ermöglicht eine besonders sichere Führung der Hilfskathoden. Außerdem bietet eine Führung der Hilfskathoden über zwei oder mehrere Umlenkrollen weitere Vorteile. So kann gemäß Anspruch 9 eine Umlenkrolle auch für den kontinuierlichen oder intervallweisen Antrieb der Hilfskathode herangezogen werden. Gemäß Anspruch 10 kann eine Umlenkrolle auch ohne besonderen Mehraufwand für die Stromzufuhr zu der Hilfskathode eingesetzt werden.

Der Einsatz von Kontaktierrollen als Kontaktierorgane ermöglicht gegenüber Kontaktierwalzen eine besonders einfache Anordnung der Hilfskathode im seitlichen Bereich der Behandlungszelle.

Bei der Ausgestaltung nach Anspruch 12 ergibt sich durch die paarweise Anordnung von oberen und unteren Kontaktierrollen eine besonders effiziente kathodische Kontaktierung der durchlaufenden Werkstücke, wobei die Entmetallisierung dieser oberen und unteren Kontaktierrollen durch die Zuordnung von separaten oberen und separaten unteren endlos umlaufenden Hilfskathoden im starken Maße begünstigt wird.

Ausführungsbeispiele der Erfindung sind in der Zeichnun dargestellt und werden im folgenden näher beschrieben.

Es zeigen
Figur 1 einen teilweisen Querschnitt durch eine Galvanisiereinrichtung zum Durchkontaktieren und Galvanisieren von Leiterplatten mit einer elektrolytischen Entmetallisierung von Kontaktierrollen durch eine Hilfskathode,
Figur 2 eine Draufsicht auf die Galvanisiereinrichtung gemäß Figur 1 und
Figur 3 die Zuordnung von Kontaktierrollen zu einer bandförmigen Hilfskathode in perspektivischer Darstellung.

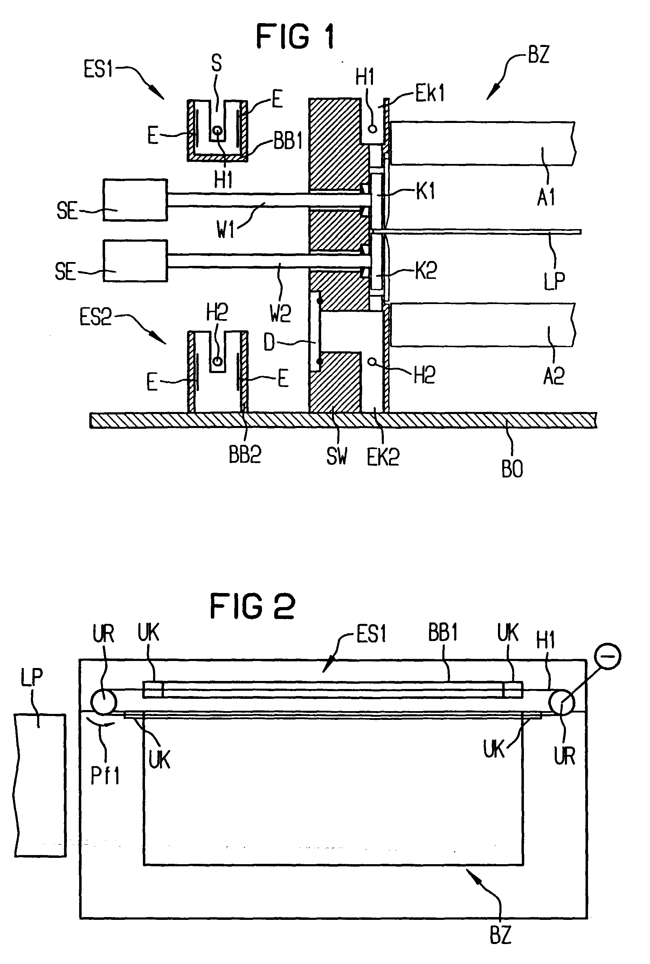

Figur 1 zeigt einen Querschnitt durch den in Durchlaufrichtung gesehen linken Bereich einer Galvanisiereinrichtung für Leiterplatten LP, die in horizontaler Lage und in horizontaler Durchlaufrichtung durch einen nicht näher erkennbaren Elektrolyten transportiert werden. Die Unterbringung dieses Elektrolyten erfolgt in einer Behandlungszelle BZ, von welcher in Figur 1 der Boden BO und eine Seitenwand SW zu erkennen sind. Im Elektrolyten sind eine obere Anode A1 und eine untere Anode A2 angeordnet, die beide im dargestellten Ausführungsbeispiel mit in der Zeichnung nicht erkennbaren Kupferkugeln gefüllt sind.

Für den Transport und für die kathodische Kontaktierung der Leiterplatten LP sind als Kontaktierrollen ausgebildete obere und untere Kontaktierorgane K1 bzw. K2 vorgesehen, die paar-weise angeordnet und jeweils auf einer Welle W1 bzw. W2 befestigt sind. Dabei ist mindestens eine dieser Wellen W1 oder W2 auf in Figur 1 nicht näher erkennbare Weise angetrieben. Die kathodische Kontaktierung der Leiterplatten LP erfolgt über die Kontaktierorgane K1 bzw. K2, deren Wellen W1 bzw. W2 und über auf den Wellen W1 bzw. W2 angeordnete Stromzufuhreinrichtungen SE1 bzw. SE2. Diese Stromzufuhreinrichtungen SE1 und SE2 sind jeweils an den Minuspol von in Figur 1 nicht erkennbaren oberen und unteren Galvanisier-Stromquellen angeschlossen, deren Pluspole mit der oberen Anode A1 bzw. mit der unteren Anode A2 verbunden sind.

Im oberen Bereich der Seitenwand SW ist eine obere Entmetallisierungkammer EK1 gebildet, in welcher sich die oberen Kontaktierorgane K1 und oberhalb davon eine sich in Durchlaufrichtung erstreckende obere Hilfskathode H1 befinden. Diese obere Hilfskathode H1 besteht im dargestellten Ausführungsbeispiel aus einem biegsamen Metalldraht, der wie es insbesondere aus Figur 2 erkennbar ist, endlos umläuft und in seinem außerhalb der Behandlungszelle BZ liegenden Rücklaufbereich durch eine obere Entmetallisierungs-Station ES1 geführt ist. Die obere Hilfskathode H1 ist gemäß Figur 2 über zwei Umlenkrollen UR geführt, wobei eine dieser Umlenkrollen in Richtung des Pfeils Pf1 angetrieben ist und wobei die andere Umlenkrolle UR mit dem durch ein Minuszeichen angedeuteten Minuspol einer in den Figuren 1 und 2 nicht erkennbaren oberen Entmetallisierungs-Stromquelle verbunden ist. Der Pluspol dieser oberen Entmetallisierungs-Stromquelle ist über die zugeordneten oberen Stromzufuhreinrichtunen SE1 und die Wellen W1 mit den oberen Kontaktierorganen K1 verbunden.

Die oberen Kontaktierorgane K1 sind somit gegenüber der oberen Anode A1 kathodisch und gegenüber der oberen Hilfskathode H1 anodisch geschaltet. Dementsprechend wird auf den oberen Kontaktierorganen K1 beim Galvanisiervorgang Kupfer abgeschieden, wobei die unerwünschten Kupferniederschläge in der oberen Entmetallisierungskammer EK1 elektrolytisch wieder abgetragen werden und sich dann auf der oberen Hilfskathode H1 niederschlagen. Beim Durchlaufen der oberen Entmetallisierungs-Station ES1 werden die Kupferniederschläge dann wieder laufend entfernt. Die obere Entmetallisierungs-Station ES1 besteht aus einem langgestreckten Badbehälter BB1, in welchem sich ein in den Figuren 1 und 2 nicht erkennbarer Elektrolyt befindet. Dieser Elektrolyt hat die gleiche Zusammensetzung wie der in der Behandlungszelle BZ enthaltene Elektrolyt. Zu beiden Seiten der durch den Badbehälter BB1 geführten oberen Hilfskathode H1 sind Elektroden E angeordnet, die gegenüber der oberen Hilfskathode H1 kathodisch geschaltet sind. Somit wird in dem oberen Badbehälter BB1 der Kupferniederschlag auf der oberen Hilfskathode H1 elektrolytisch wieder abgetragen und auf den Elektroden E niedergeschlagen. Diese Elektroden E können dann von Zeit zu Zeit ausgetauscht werden, wobei dieser Austausch ohne Stillsetzung der Galvanisiereinrichtung vorgenommen werden kann. Um die Führung der oberen Hilfskathode H1 durch die Behandlungszelle BZ und durch den oberen Badbehälter BB1 zu ermöglichen, sind die entsprechenden Stirnwände in den Ein- und Austrittsbereichen jeweils mit vertikal ausgerichteten Schlitzen versehen. Einer dieser Schlitze S des oberen Badbehälters BB1 ist in Figur 1 zu erkennen. Außerdem sind in den Ein- und Austrittbereichen Überlaufkammern UK vorgesehen, welche den auslaufenden Elektrolyten auffangen, so daß er über in der Zeichnung nicht dargestellte Pumpen in die Behandlungszelle BZ bzw. den oberen Badbehälter BB1 zurückgeführt werden kann. Für einen ungestörten Durchtritt der oberen Hilfskathode H1 sind die äußern Stirnwände der Überlaufkammern UK ebenfalls mit entsprechenden Schlitzen S versehen.

Bei der vorstehend geschilderten Anordnung von Schlitzen und Überlaufkammern im Ein- und Austrittsbereich von Durchlaufanlagen handelt es sich um eine in der Galvanotechnik seit langem bekannte Maßnahme. Nähere Einzelheiten hierzu gehen beispielsweise aus der US-A-3 287 238 hervor.

Im unteren Bereich der Seitenwand SW ist eine untere Entmetallisierungskammer EK2 gebildet, in welcher sich die unteren Kontaktierorgane K2 und unterhalb davon eine sich in Durchlaufrichtung erstreckende untere Hilfskathode H2 befinden. Diese untere Hilfskathode H2 besteht wieder aus einem biegsamen Metalldraht, der auf gleiche Weise, wie die obere Hilfskathode H1 endlos in einer horizontalen Ebene umläuft und in seinem außerhalb der Behandlungszelle BZ liegenden Rücklaufbereich durch eine untere Entmetallisierungs-Station ES2 geführt ist. Die untere Hilfskathode H2 ist wie die obere Hilfskathode H1 über in der Zeichnung nicht erkennbare Umlenkrollen geführt, wobei eine dieser Umlenkrollen angetrieben ist und die andere Umlenkrolle mit dem Minuspol einer ebenfalls in der Zeichnung nicht dargestellten unteren Entmetallisierungs-Stromquelle verbunden ist. Der Pluspol dieser unteren Entmetallisierungs-Stromquelle ist über die unteren Stromzufuhreinrichtungen SE2 und die Wellen W2 mit den unteren Kontaktierorganen K2 verbunden.

Es ist erkennbar, daß das auf den unteren Kontaktierorganen K2 beim Galvanisiervorgang abgeschiedene Kupfer in der unteren Entmetallisierngskammer EK2 elektrolytisch wieder abgetragen und auf der unteren Hilfskathode H2 niedergeschlagen wird. Die Entmetallisierung der unteren Hilfskathode H2 erfolgt dann in dem Badbehälter BB2 der unteren Entmetallisierungs-Station ES2 durch elektrolytischen Abtrag, so wie es am Beispiel der oberen Entmetallisierungs-Station ES1 bereits beschrieben wurde.

Müssen die Hilfskathoden H1 und H2 einmal austauscht werden, so kann die obere Hilfskathode H1 auf einfache Weise nach oben entnommen bzw. von oben her eingesetzt werden. Im Falle der unteren Hilfskathode H2 muß bei einem Austausch zunächst der Elektrolyt in der Behandlungszelle BZ abgelassen und ein Deckel D in der Seitenwand SW geöffnet werden.

Weitere Einzelheiten und auch Variationsmöglichkeiten der vorstehend anhand der Figuren 1 und 2 beschriebenen Galvani-siereinrichtung gehen -mit Ausnahme der Entmetallisierung der endlos umlaufenden Hilfskathoden- aus der eingangs erwähnten EP-B-0 578 699 hervor. Bei einer konstanten Breite der in der Galvanisiereinrichtung zu behandelnden Leiterplatten LP kann die beschriebene Anordnung von Kontaktierorganen K1, K2 von Hilfskathoden H1, H2 und von Entmetallisierungs-Stationen ES1, ES2 auch spiegelsymmetrisch auf der in Durchlaufrichtung gesehen gegenüberliegenden Seite der Galvanisiereinrichtung vorgenommen werden.

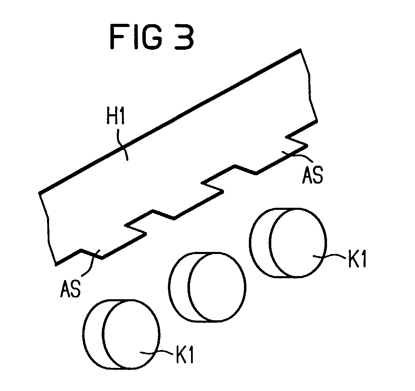

Figur 3 zeigt am Beispiel der oberen Hilfskathode H1 eine Variante. Die biegsame obere Hilfskathode H1 besteht hier aus einem vertikal ausgerichteten Band, welches horizontal ausgerichtete und den Stirnseiten der oberen Kontaktierorgane K1 zugeordnete Ansatzstücke AS trägt. Durch die zahnförmige An-ordnung dieser Ansatzstücke AS ist die für den endlosen Umlauf der oberen Hilfskathode H1 erforderliche Biegsamkeit des Bandes gewährleistet. Die untere Hilfskathode kann dann in entsprechender Weise ebenfalls bandförmig mit oben liegenden Ansatzstücken ausgebildet werden.

## Patentansprüche

1. Galvanisiereinrichtung für im horizontalen Durchlauf zu behandelnde Werkstücke, insbesondere Leiterplatten (LP), mit
- mindestens einer Behandlungszelle (BZ) zur Aufnahme eines Elektrolyten,
- mindestens einer im Elektrolyten angeordneten Anode (A1, A2),
- mindestens einer im Elektrolyten angeordneten Hilfskathode (H1,H2) und mit
- im Elektrolyten drehbar angeordneten Kontaktierorganen (K1, K2) zur kathodischen Kontaktierung der durchlaufenden Werkstücke, wobei
- die Kontaktierorgane (K1,K2) in bezug auf die Hilfskathode (H1, H2) anodisch geschaltet sind,
**gekennzeichnet** durch
- eine biegsame, endlos umlaufende Hilfskathode (H1, H2), die in ihrem außerhalb der Behandlungszelle (BZ) liegenden Rücklaufbereich durch mindestens eine EntmetallisierungsStation (ES1, ES2) geführt ist.

2. Galvanisiereinrichtung nach Anspruch 1,
dadurch **gekennzeichnet**,
daß die endlos umlaufende Hilfskathode (H1, H2) durch einen Draht, ein Band, eine Schnur oder eine Kette gebildet ist.

3. Galvanisiereinrichtung nach Anspruch 1 oder 2,
dadurch **gekennzeichnet**,
daß die Hilfskathode (H1, H2) in einer horizontalen Ebene umläuft.

4. Galvanisiereinrichtung nach Anspruch 3,
dadurch **gekennzeichnet**,
daß die Hilfskathode (H1, H2) horizontal ausgerichtete und den Stirnseiten der Kontaktierorgane (K1,K2) zugeordnete Ansatzstücke (AS) trägt.

5. Galvanisiereinrichtung nach einem der Ansprüche 1 bis 4,
dadurch **gekennzeichnet**,
daß die Entmetallisierungs-Station (ES1, ES2) durch ein in einem Badbehälter (BB1,BB2) aufgenommenes Entmetallisierungsbad gebildet ist.

6. Galvanisierungseinrichtung nach Anspruch 5,
dadurch **gekennzeichnet**,
daß als Entmetallisierungsbad eine Ätzlösung vorgesehen ist.

7. Galvanisiereinrichtung nach Anspruch 5,
dadurch **gekennzeichnet**,
daß als Entmetallisierungsbad ein Elektrolyt vorgesehen ist und daß in diesem Elektrolyten mindestens eine gegenüber der Hilfskathode (H1,H2) kathodisch geschaltete Elektrode (E) angeordnet ist.

8. Galvanisiereinrichtung nach einem der Ansprüche 1 bis 7
dadurch **gekennzeichnet**,
daß die Hilfskathode (H1, H2) über mindestens zwei Umlenkrollen (UR) geführt ist.

9. Galvanisiereinrichtung nach Anspruch 8,
dadurch **gekennzeichnet**,
daß mindestens eine Umlenkrolle (UR) kontinuierlich oder intervallweise antreibbar ist.

10. Galvanisiereinrichtung nach Anspruch 8 oder 9,
dadurch **gekennzeichnet**,
daß über mindestens eine Umlenkrolle die Stromzuführung zu der Hilfskathode (H1, H2) erfolgt.

11. Galvanisiereinrichtung nach einem der Ansprüche 1 bis 10,
dadurch **gekennzeichnet**,
daß als Kontaktierorgane (K1, K2) Kontaktierrollen vorgesehen sind.

12. Galvanisiereinrichtung nach Anspruch 11,
dadurch **gekennzeichnet**,
daß entlang mindestens einer Seite des horizontalen Durchlaufweges der Werkstücke obere und untere Kontaktierrollen paarweise angeordnet sind, daß den oberen Kontaktierrollen einer Seite eine obere endlos umlaufende Hilfskathode (H1) zugeordnet ist und daß den untern Kontaktierrollen einer Seite eine untere endlos umlaufende Hilfskathode (H2) zugeordnet ist.
